# EUROPEAN PATENT SPECIFICATION

(11) **EP 2 476 710 B1**
(45) Date of publication and mention of the grant of the patent: **18.03.2015**
(21) Application number: 10823186.1
(22) Date of filing: 12.10.2010
(51) Int. Cl.: C08F 4/46, C08F 2/44, C08K 9/00, C08L 53/02, G03F 7/00, G03F 7/032

(54) **METHOD FOR PRODUCING POLYBUTADIENE**
VERFAHREN ZUR HERSTELLUNG VON POLYBUTADIEN
PROCÉDÉ DE PRODUCTION DE POLYBUTADIÈNE

(30) Priority: 14.10.2009 JP 2009237675
(43) Date of publication of application: 18.07.2012
(73) Proprietor: Nippon Soda Co., Ltd., Tokyo 100-8165 (JP)
(72) Inventor: SHIRAI, Akihiro, Ichihara-shi Chiba 290-0045 (JP); MIYASHITA, Yasunori, Ichihara-shi Chiba 290-0045 (JP); SHIMOTORI, Takeshi, Joetsu-shi Niigata 949-2392 (JP)
(74) Representative: Cabinet Plasseraud
(86) International application number: PCT/JP2010/006054
(87) International publication number: WO 2011/045918

(56) References cited:
- EP-A1- 2 258 765
- WO-A1-2006/049016
- WO-A1-2008/114756
- WO-A1-2009/133888
- WO-A1-2010/116743
- JP-A- 6 239 909
- JP-A- 9 227 628
- JP-A- 9 227 636
- JP-A- 11 209 439
- JP-A- 57 034 104
- JP-A- 2002 206 003
- JP-A- 2004 027 103
- JP-A- 2005 272 643
- JP-A- 2006 206 872
- JP-A- 2006 257 261
- JP-A- 2006 274 178
- JP-A- 2007 070 642
- JP-A- 2007 211 240
- JP-A- 2009 006 601
- US-A- 4 225 690
- US-A1- 2003 092 803

## Description

### Technical Field

The present invention relates to an anionic polymerization method for a polybutadiene whereby a ratio of 1,4-structure and 1,2-structure can be controlled, and a photosensitive elastomer composition for flexographic printing comprising the polybutadiene produced by the method. The present invention also relates to an adhesive composition comprising a terminal acrylic-modified polybutadiene derived from the polybutadiene.

The present application claims priority from Japanese Patent Application No. 2009-237675 filed on Oct. 14, 2009, the content of which is incorporated herein.

### Background Art

A polybutadiene contains 1,2-structure, cis-1,4-structure, and trans-1,4-structure and has very different physical properties depending upon a ratio of these structures, namely a microstructure ratio. Therefore, there are various demands from users, and a method whereby the microstructure ratio can be easily controlled is required for providing products in accordance with the users' demands.

While examples of a method for producing a polybutadiene from 1,3-butadiene include radical polymerization, anionic polymerization, and cationic polymerization, among them, the production of a polybutadiene by the anionic polymerization is a method known from old times as described in Patent Document 1.

In that case, 1,3-butadiene has a boiling point of-4.4°C and is gas at room temperature. Therefore, when the polymerization is conducted at room temperature or a temperature equal to or higher than the boiling point, a pressure-resistant reactor such as an autoclave is required. When the polymerization reaction is conducted at low temperatures, a special pressure-resistant reactor is not required because 1,3-butadiene is liquid at low temperatures. In addition, by conducting the anionic polymerization at low temperatures, it is possible to control a molecular weight arbitrarily, and then, to obtain a polybutadiene having a molecular weight distribution within a narrow range.

The polybutadiene thus obtained contains, based on the microstructures in its polymer chain, about 80% by mole or more of 1,2-structure and the rest is 1,4-structure. Accordingly, conducting the anionic polymerization at low temperatures has provided only the polybutadiene containing about 80% or more of 1,2-structure.

On the other hand, Non-patent document 1 discloses that the microstructure ratio in a polybutadiene can be changed by changing a polar solvent, a temperature, or an additive. The document involves an experiment using an alkali metal such as lithium, sodium, and potassium as the additive, and discloses that the microstructure changes depending on the type of the alkali metal.

The document also discloses a relation between the microstructure and a mole ratio of a t-butoxy alkali metal salt to n-BuLi (0.05 to 1) at 30°C in the presence of cyclohexane which is a nonpolar solvent, and the relation is that, when the mole ratio of a t-butoxy alkali metal salt to n-BuLi becomes larger, the ratio of 1,2-structure increases and the ratio of trans-1,4-structure decreases. The document further discloses that a lower reaction temperature leads to an increased ratio of 1,2-linkage. Accordingly, it can not be expected that 1,4-structure can be increased by adding a t-butoxy alkali metal salt at a low temperature not higher than the boiling point of 1,3-butadiene (-4.4°C).

### Prior Art Documents

### Patent Documents

Patent Document 1: Japanese Patent Publication No. 44-27469

### Non-Patent Documents

Non-Patent Document 1: ANIONIC POLYMERIZATION Principles and Practical Applications, (1996), p. 197-236.

### Summary of the Invention

### Object to be Solved by the Invention

An object of the present invention is to produce polybutadienes having diverse physical properties by controlling the microstructures of the polybutadienes in a method for producing a polybutadiene by anionic polymerization at a low temperature.

### Means to Solve the Object

As a result of diligent study, the present inventors completed the present invention upon discovering the fact that trans-1,4-structure can be easily increased for the first time by using an aprotic polar solvent and a potassium salt such as potassium t-butoxide when a polybutadiene is produced by anionic polymerization of 1,3-butadiene at a low temperature not higher than the boiling point of 1,3-butadiene.

That is, the present invention provides,
(1) A method for producing a polybutadiene by anionic polymerization of 1,3-butadiene in the presence of a polymerization initiator under the conditions of a reaction temperature not higher than a boiling point of butadiene, wherein the polymerization is carried out in the presence of a potassium salt in an aprotic polar solvent or in a mixed solvent of an aprotic polar solvent and a nonpolar solvent;
(2) The method for producing a polybutadiene according to (1), wherein the potassium salt is potassium t-butoxide; and
(3) The method for producing a polybutadiene according to (1) or (2), wherein the mixed solvent of an aprotic polar solvent and a nonpolar solvent is a mixed solvent of tetrahydrofuran and hexane.

The present invention also provides,
(4) A polybutadiene produced by the method according to any one of (1) to (3), having a microstructure ratio of 1,2-structure/1,4-structure ranging from 55/45 to 80/20 (% by mole) and having a molecular weight distribution ranging from 1.01 to 1.30;
(5) A plate-making material composition for flexographic printing, comprising:
   (A) 50 to 90% by mass of a thermoplastic elastomer;
   (B) 5 to 40% by mass of the polybutadiene produced by the method according to any one of (1) to (3);
   (C) 1 to 30% by mass of an ethylenically unsaturated compound; and
   (D) 0.1 to 3% by mass of a photopolymerization initiator, and
   exhibiting an elastic modulus ranging from 80 to 150 MPa after being cured by light; and
(6) The plate-making material composition for flexographic printing according to (5), wherein the thermoplastic elastomer is a styrene-butadiene-styrene block polymer and/or a styrene-isoprene-styrene block polymer.

The present invention further provides,
(7) An adhesive composition comprising a terminal acrylic-modified polybutadiene derived from the polybutadiene produced by the method according to any one of (1) to (3);
(8) The adhesive composition according to (7), wherein the terminal acrylic-modified polybutadiene is represented by formula (I) 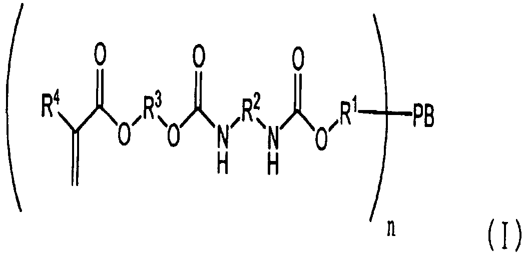 (wherein R¹ to R³ each independently represent a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof; R⁴ represents a hydrogen atom or a methyl group; PB represents the polybutadiene produced by the method according to any one of (1) to (3); and n represents 1 or 2).

### Effect of the Invention

Conventionally, in the case of anionic polymerizing 1,3-butadiene at low temperatures not higher than the boiling point of 1,3-butadiene, only a polybutadiene having about 80% by mole or more of 1,2-structure has been produced. On the contrary, the present invention allows trans-1,4-structure to be increased to about 50% by mole based on the microstructures of polybutadiene even in the case where such an anionic polymerization is employed, and then, enables to increase the utility value of the polybutadiene produced by the low-temperature polymerization method. This result is the opposite of the result experimented at 30°C disclosed in Non-patent document 1, and can not be predicted from the document.

It is noted that, unlike in the case of the potassium salt, trans-1,4-polybutadiene can not be increased by using other types of alkali metal salts. It is also noted that trans-1,4-polybutadiene can not be increased in a nonpolar solvent, even if the potassium salt is used. Therefore, it can be said that the present invention involves a specific reaction that occurs only when the aprotic polar solvent and the potassium salt are used in combination.

When trans-1,4-polybutadiene is increased, effects such as a drastic decrease in a viscosity of polybutadiene and a decrease in a glass transmission temperature are exerted. Then, it has been identified that, when the polybutadiene of the present invention is used as a plasticizer for the plate-making material for flexographic printing, its elastic modulus is improved.

It has been found that the adhesive comprising a terminal acrylic-modified polybutadiene derived from the polybutadiene of the present invention exhibits a higher tensile shear strength.

### Mode of Carrying Out the Invention

### (Method for producing polybutadiene)

A method for producing a polybutadiene of the present invention consists of anionic polymerizing 1,3-butadiene in an aprotic polar solvent or in a mixed solvent of an aprotic polar solvent and a nonpolar solvent at a temperature not higher than the boiling point of 1,3-butadiene by using an alkali metal or an organic alkali metal as a polymerization initiator and adding a potassium salt. The polymerization reaction of the present invention may be carried out by any of the following methods: a method of adding dropwise the polymerization initiator and the potassium salt to a solution of 1,3-butadiene monomer; a method of adding dropwise liquefied 1,3-butadiene monomer directly to a solution comprising the polymerization initiator and the potassium salt; and a method of adding dropwise an aprotic polar solvent solution or a nonpolar solvent solution of 1,3-butadiene monomer to a solution comprising the polymerization initiator and the potassium salt. However, in view of controlling a molecular weight and a molecular weight distribution, the method of adding dropwise liquefied 1,3-butadiene monomer directly to a solution comprising the polymerization initiator and the potassium salt, and the method of adding dropwise an aprotic polar solvent solution or a nonpolar solvent solution of 1,3-butadiene monomer to a solution comprising the polymerization initiator and the potassium salt are preferred. The reaction is generally carried out in an inert gas atmosphere such as nitrogen and argon at a temperature ranging from -100°C to the boiling point of 1,3-butadiene (-4.4°C), preferably ranging from -60 to -10°C. After polymerization, the polymerization is terminated by adding a compound comprising an active hydrogen such as water and methanol, and then, a resultant polybutadiene can be purified by known methods.

In stead of adding the compound comprising an active hydrogen, an hydroxyl group can be introduced at the terminal by adding an epoxy compound such as ethylene oxide and styrene oxide.

Examples of the alkali metal serving as the polymerization initiator include lithium, sodium, potassium, and cesium, and examples of the organic alkali metal serving as the polymerization initiator include an alkylated compound, an allylated compound, and an arylated compound of the aforementioned alkali metal. Examples of such a compound include ethyllithium, n-butyllithium, s-butyllithium, t-butyllithium, ethylsodium, lithiumbiphenyl, lithiumnaphthalene, lithiumtriphenyl, sodiumbiphenyl, sodiumterphenyl, sodiumnaphthalene, sodiumtriphenyl, 1,1-diphenylhexyllithium, and 1,1-diphenyl-3-methylpentyllithium.

Examples of the potassium salt include potassium salts other than the aforementioned organic alkali metal, and specifically include a potassium halide salt such as potassium chloride, potassium bromide, potassium fluoride, and potassium iodide; a potassium carbonate salt such as potassium carbonate and potassium hydrogen carbonate; a potassium salt of an inorganic acid such as potassium sulphate and potassium nitrate; potassium hydroxide; a potassium salt of a C1 to C10 organic acid such as potassium formate, potassium acetate, potassium propionate, potassium butyrate, potassium isobutyrate, potassium methacrylate, and potassium acrylate; a potassium fluoborate salt such as potassium tetrafluoborate; a potassium phosphate salt such as potassium hexafluorophosphate; potassium tetraphenylborate; potassium hexamethyldisilazide; and a C1 to C6 alkoxy potassium salt such as potassium methoxide, potassium ethoxide, potassium isopropoxide, potassium n-butoxide, and potassium t-butoxide. The C1 to C6 alkoxy potassium salt such as potassium t-butoxide is preferred.

Examples of the aprotic polar solvent include an ether solvent such as diethyl ether, tetrahydrofuran (THF), and dioxane; an amide solvent such as N,N-dimethylformamide (DMF), N,N-dimethylacetamide (DMA), and N-methylpyrrolidine-2-one (NMP); a nitrile solvent such as acetonitrile; and 1,3-dimethylimidazolidine-2-one (DMI). These compounds can be used alone or as a mixed solvent of two or more kinds.

Examples of the nonpolar solvent include nonpolar organic solvents commonly used in the anionic polymerization such as aliphatic hydrocarbons such as n-hexane and n-heptane; alicyclic hydrocarbons such as cyclohexane and cyclopentane; and aromatic hydrocarbons such as benzene and toluene, and these compounds can be used alone or as a mixed solvent of two or more kinds.

Examples of the combination of the aprotic polar solvent and the nonpolar solvent include diethyl ether and n-hexane; THF and n-hexane; dioxane and n-hexane; DMF and n-hexane; diethyl ether and toluene; THF and toluene; dioxane and toluene; and DMF and toluene.

While there is no restriction on a mixing ratio thereof, the ratio of aprotic polar solvent/nonpolar solvent is 99/1 to 1/99 (ratio in % by mass).

Examples of the combination of the potassium salt and the solvent include potassium chloride and THF; potassium chloride and DMF; potassium n-butoxide and THF; potassium n-butoxide and DMF; potassium t-butoxide and THF; potassium t-butoxide and DMF; potassium chloride and a mixed solvent of THF and n-hexane; potassium chloride and a mixed solvent of DMF and n-hexane; potassium n-butoxide and a mixed solvent of THF and n-hexane; potassium n-butoxide and a mixed solvent of DMF and n-hexane; potassium t-butoxide and a mixed solvent of THF and n-hexane; and potassium t-butoxide and a mixed solvent of DMF and n-hexane.

A ratio of microstructures (1,2-structure, cis-1,4-structure and trans-1,4-structure) in the polybutadiene of the present invention can be calculated by using ¹H-NMR. Specifically, the microstructure ratio of 1,2- and 1,4-can be calculated from integral values of CH proton signals and CH₂ proton signals for -CH=CH₂ of 1,2-structure and integral values of two CH proton signals for -CH=CH- of 1,4-structure.

The microstructure ratio in the polybutadiene of the present invention can be adjusted by changing the amount of the potassium salt used. Generally, the potassium salt can be added in an amount of 0.05 to 2 moles relative to 1 mole of the polymerization initiator, and the ratio of 1,4-structure increases with increasing the amount of the potassium salt added. When the added amount of the potassium salt equivalent to 1 mole of the polymerization initiator exceeds 1.0 mole, the ratio of 1,4-structure does not increase any more.

The polybutadiene thus obtained has a microstructure ratio (% by mole) of 1,2-structure/1,4-structure ranging from 45/55 to 90/10, preferably ranging from 50/50 to 80/20, more preferably ranging from 55/45 to 80/20. Almost all of the 1,4-structures are trans-1,4-structures. IR spectrum of the polybutadiene of the present invention revealed that almost all of the 1,4-structures are trans-1,4-structures.

The number average molecular weight and the molecular weight distribution of the polybutadiene produced by the method of the present invention can be measured by GPC using polystyrene as a standard substance.

The number average molecular weight can be measured also by ¹H-NMR, and in that case, the measurement is performed as follows.

When n-butyllithium or sec-butyllithium is used as the polymerization initiator in the production of polybutadiene of the present invention, methyl signals of a butyl group of the polymerization initiator bonded to the polymer at the terminal appears within the range of 0.8 to 0.9 ppm in the ¹H-NMR spectrum. Therefore, the number average molecular weight can be calculated from the integral values of the methyl signals and integral values of olefin proton signals of a butadiene unit.

The polybutadiene of the present invention has a number average molecular weight measured by GPC ranging from 500 to 20,000, and has a molecular weight distribution (weight average molecular weight (Mw)/number average molecular weight (Mn)) ranging from 1.01 to 1.30.

### (Plate-making material composition for flexographic printing)

Flexographic printing is a relief printing method using a liquid ink and a plate consisting of an elastic substance such as a rubber resin, and is used for printing for cardboards, plastic films, or the like.

The polybutadiene produced by the method of the present invention can be used as a plasticizer in a plate-making material composition used for flexographic printing plates.

The plate-making material composition for flexographic printing of the present invention consists of the following composition.
(A) 50 to 90% by mass of a thermoplastic elastomer,
(B) 5 to 40% by mass of the polybutadiene produced by the method of the present invention,
(C) 1 to 30% by mass of an ethylenically unsaturated compound, and
(D) 0.1 to 3% by mass of a photopolymerization initiator

Moreover, the plate-making material composition for flexographic printing of the present invention exhibits an elastic modulus ranging from 80 to 150 MPa after being cured by light.

The light curing and measurement of the elastic modulus can be carried out by the following procedure.

The plate-making material composition for flexographic printing is dissolved in cyclohexane so that the content of a nonvolatile component adjusts 20% by mass, and is air-dried in an aluminum cup overnight, and then, dried at 50°C for 5 hours. After that, light is irradiated using an ultra high pressure mercury lamp of 10 mW so that an integrated light quantity becomes about 6000 mJ/cm².

The composition having a film shape after being cured by light is peeled off from the aluminum cup, and a test piece having a length of 25 mm, a width of 5 mm, and a thickness of 0.8 mm is cut out. The test piece is subjected to a tensile test using SHIMADZU Autograph (AGS-J), and the elastic modulus is calculated. The test is performed under the conditions of the distance between chucks of 20 mm and the test rate of 20 mm/minute.

The thermoplastic elastomer used in the plate-making material composition for flexographic printing of the present invention is an elastomer which exhibits rubber elasticity at around room temperature, is hard to be plastically deformed, and is plasticized by heat when mixing the composition in an extruder or the like. Examples of the thermoplastic elastomer include a thermoplastic elastomeric blockcopolymer comprising at least one first polymer block composed mainly of a conjugated diene unit or a hydrogenated conjugated diene unit and at least one second polymer block composed mainly of a vinyl aromatic hydrocarbon unit, such as a styrene·butadiene blockcopolymer, a styrene·isoprene blockcopolymer, a styrene·ethylene/butylene blockcopolymer, and a styrene·butadiene rubber; an olefin-based thermoplastic elastomer such as an EPDM and a propylene·ethylene/propylene blockcopolymer; a polyurethane-based thermoplastic elastomer; a polyester-based thermoplastic elastomer; a polyamide-based thermoplastic elastomer; a vinyl chloride-based thermoplastic elastomer; a fluorine-based thermoplastic elastomer; and a silicone-based thermoplastic elastomer. These thermoplastic elastomers can be used alone or in combination of two or more.

The thermoplastic elastomer is contained in an amount ranging from 50 to 90% by mass, more preferably ranging from 50 to 75% by mass, based on the total amount of the composition.

The polybutadiene used in the plate-making material composition for flexographic printing of the present invention is a liquid polybutadiene produced by the method described above. The polybutadiene has a microstructure ratio (% by mole) of 1,2-structure/1,4-structure ranging from 45/55 to 90/10, preferably ranging from 50/50 to 80/20, more preferably ranging from 55/45 to 80/20. When the ratio of 1,2-linkage is too small, a compatibility with the thermoplastic elastomer becomes lower, which results in a larger turbidity. On the other hand, when the ratio of 1,2-linkage is too large, the resultant composition loses the rubber elasticity.

The polybutadiene is contained in an amount preferably ranging from 1.0 to 80.0% by mass, more preferably ranging from 5.0 to 50.0% by mass, based on the total amount of the composition. When the amount of the polybutadiene is too small, an ink can not spread sufficiently on a solid portion when performing printing on an object with a lower-quality paper such as a cardboard having a rough surface and a recycled paper. On the other hand, when the amount is too large, an uncured plate exhibits a large deformation at the time of storage and transportation, and so the plate can not be used as the printing plate.

Examples of the ethylenically unsaturated compound used in the plate-making material composition for flexographic printing of the present invention include esters of acrylic acid, methacrylic acid, fumaric acid, maleic acid, and the like; a derivative of acrylamide or methacrylamide, allyl ester, styrene and a derivative thereof, and a N-substituted maleimide compound. Specific examples include, but are not limited to, diacrylate and dimethacrylate of ethylene glycol, diethylene glycol, propylene glycol, dipropylene glycol, polyethylene glycol, polypropylene glycol, butylene glycol, hexamethylene glycol, or nonamethylene glycol; trimethylolpropane triacrylate, trimethylolpropane trimethacrylate, pentaerythritol tetraacrylate, tetramethacrylate, 1,6-hexanediol diacrylate, diacetone acrylamide, diacetone methacrylamide, styrene, vinyltoluene, divinylbenzene, diallyl phthalate, triallyl cyanurate, fumaric acid diethyl ester, fumaric acid dibutyl ester, fumaric acid dioctyl ester, fumaric acid distearyl ester, fumaric acid butyloctyl ester, fumaric acid diphenyl ester, fumaric acid dibenzyl ester, maleic acid dibutyl ester, maleic acid dioctyl ester, fumaric acid bis (3-phenylpropyl) ester, fumaric acid dilauryl ester, fumaric acid dibehenyl ester, N-n-hexylmaleimide, N-cyclohexylmaleimide, N-n-octylmaleimide, N-2-ethylhexylmaleimide, N-n-decylmaleimide, and N-n-laurylmaleimide. These compounds can be used alone or in combination of two or more.

The ethylenically unsaturated compound is contained in an amount preferably ranging from 1.0 to 30.0% by mass, more preferably ranging from 5.0 to 10.0% by mass, based on the total amount of the composition. When the amount is too small, the quality of a small dot or letter is deteriorated. On the other hand, when the amount is too large, an uncured plate exhibits a large deformation at the time of storage and transportation, the obtained plate comes to have a higher hardness, and an ink can not spread sufficiently on a solid portion when performing printing on an object with a lower-quality paper such as a cardboard having a rough surface and a recycled paper.

Examples of the photopolymerization initiator used in the plate-making material composition for flexographic printing of the present invention include, but are not limited to, benzophenone, benzoin, benzoin methyl ether, benzoin ethyl ether, benzoin isopropyl ether, benzoin isobutyl ether, α-methylolbenzoin, α-methylolbenzoin methyl ether, α-methoxybenzoin methyl ether, benzoin phenyl ether, α-t-butylbenzoin, and benzyl methyl ketal. These compounds can be used alone or in combination of two or more. The photopolymerization initiator is contained in an amount preferably ranging from 0.1 to 10.0% by mass, more preferably ranging from 1.0 to 3.0% by mass, based on the total amount of the composition. When the amount is too small, the quality of a small dot or letter is deteriorated. On the other hand, when the amount is too large, activated light transmittance of the photosensitive elastomer composition decreases, which rather leads to a decrease in exposure sensitivity.

In addition to the aforementioned essential components, the plate-making material composition for flexographic printing of the present invention may comprise various types of auxiliary additional components commonly used in ordinary photosensitive resin compositions, such as a thermal polymerization inhibitor, an ultraviolet absorbing agent, an antihalation agent, and a light stabilizer, as needed.

In view of maintaining dimensional accuracy as the printing plate, the plate-making material composition for flexographic printing of the present invention may be used in a configuration in which a support layer composed of a polyester, or the like is formed on the back of a relief plate. Since the composition of the present invention has adhesion depending on its composition, a flexible film layer having a lower solubility to a solvent may be provided thereon in order to achieve an improved contact with a transparent image carrier (negative film) overlapped thereon and enabling reuse of the transparent image carrier. As the flexible film layer, a polyamide, a cellulose derivative, or the like is generally used.

The plate-making material composition for flexographic printing of the present invention can be produced by mixing the components. One example of the mixing method include a method of dissolving the components in an appropriate solvent such as chloroform, tetrachloroethylene, methyl ethyl ketone, toluene, ethyl acetate, tetrahydrofuran, hexane, and cyclohexane, and mixing them. After that, the mixed components are cast in a mold form and the solvent is evaporated, and the resultant object may be used directly as the plate, or the plate composed of the photosensitive elastomer composition may be subjected to hot press treatment to obtain a layer with a good accuracy. Alternatively, the components may be mixed using a kneader, a roll mill, or the like, and then, formed into a layer with a required thickness by heat press forming, calendering treatment, or extrusion. The support and the flexible film layer may be attached to the photosensitive layer by roll laminating after the sheet is formed. It is possible to obtain a photosensitive layer with a higher accuracy by performing heat press treatment after the laminating.

Examples of a source of activated light used for making the composition of the present invention insoluble to a solvent include a low-pressure mercury lamp, a middle-pressure mercury lamp, a high-pressure mercury lamp, an ultra high pressure mercury lamp, a metal halide lamp, a fluorescent light for an ultraviolet light, a carbon-arc lamp, a xenon lamp, a zirconium lamp, and sunlight. As a developer for eluting an unexposed portion after irradiating the composition of the present invention with light through the transparent image carrier to form an image thereon, a developer swelling and dissolving the unexposed portion, preferably having less impact on the image portion formed by exposure is used. Examples of the developer include tetrachloroethylene, toluene, acetate esters, limonene, decahydronaphthalene, petroleum-based aromatic hydrocarbons, and a mixture of the compound and 60% by weight or less of an alcohol such as n-butanol, 1-pentanol, and benzyl alcohol. The eluting of the unexposed portion is conducted by spraying from a nozzle or by blushing by a blush. Since the printing plate obtained by elution of the unexposed portion using the solvent is swelled by the developing solvent, drying is performed in a forced air current or an infrared oven. The drying is generally performed at a drying temperature of 60°C for 30 to 120 minutes. The composition of the present invention sometimes remains tacky on the plate surface after being dried depending on its composition. In that case, it is possible to remove the tackiness by a known surface treating method. As the surface treating method, an exposure treatment using activated light having a wavelength of 300 nm or less is preferred.

### (adhesive composition)

An adhesive composition of the present invention comprises a terminal acrylic-modified polybutadiene derived from the polybutadiene produced by the method of the present invention.

The terminal acrylic-modified polybutadiene used in the adhesive composition of the present invention is derived from the polybutadiene produced by the method of the present invention. An example of a method of producing the terminal acrylic-modified polybutadiene from the polybutadiene produced by the method of the present invention includes, but is not limited to, a method comprising following steps (i) and (ii), while conventionally known methods can be used as the method.

### (i) Step of introducing a hydroxyl group at a terminal of polybutadiene

Examples of the introduction of a hydroxyl group at a terminal of the polybutadiene polymer to produce a terminal hydroxyl-modified polybutadiene represented by formula (II):

PB (R¹OH)ₙ (II)

(wherein R¹ represents a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof; PB represents the polybutadiene produced by the method of the present invention; and n represents 1 or 2) include adding an epoxy compound to a reaction solution obtained by polymerizing butadiene by the aforementioned producing method. Examples of the epoxy compound used herein include ethylene oxide, propylene oxide, and styrene oxide.

### (ii) Step of introducing a (meth)acrylate group at a terminal

Examples of the introduction of a (meth)acrylate group to the polybutadiene having a hydroxyl group at a terminal obtained by the step (i) include reacting a (meth)acrylate represented by formula (III): 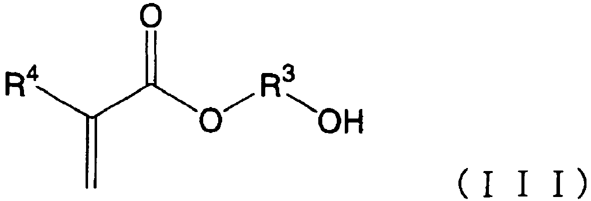 (wherein R⁴ represents a hydrogen atom or methyl group; R³ represents a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof), a diisocyanate compound represented by formula (IV): 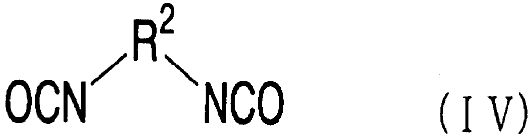 (wherein R² represents a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof), and the polybutadiene having a hydroxyl group at a terminal, to produce a terminal acrylic-modified polybutadiene represented by the formula (I): 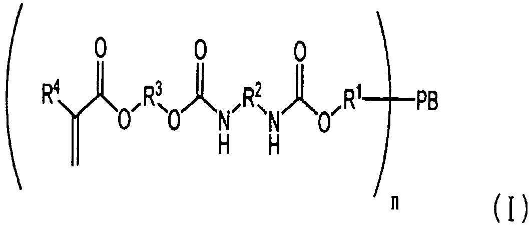 (wherein R¹ to R³ each independently represent a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof; R⁴ represents a hydrogen atom or a methyl group; PB represents the polybutadiene produced by the method of the present invention; and n represents 1 or 2).

In the formulas (I) to (IV), the substituent groups are defined as follows.

Examples of the "divalent straight or branched chain alkylene group having 1 to 10 carbon atoms" include a methylene group, an ethylene group, a propylene group, a methylethylene group, a butylene group, a 1,2-dimethylethylene group, a pentylene group, a 1-methylbutylene group, a 2-methylbutylene group, a hexylene group, and an ethylhexylene group.

Examples of the "alkyl group having 1 to 6 carbon atoms" in the "cycloalkylene group having 3 to 8 carbon atoms which may contain an alkyl group having 1 to 6 carbon atoms as a substituent group" and the "aromatic ring having 5 to 7 carbon atoms which may contain an alkyl group having 1 to 6 carbon atoms as a substituent group" include a methyl group, an ethyl group, a n-propyl group, an isopropyl group, a n-butyl group, a 1-methyl-n-propyl group, a 2-methyl-n-propyl group, a tert-butyl group, a n-pentyl group, a 1-methyl-n-butyl group, a 2-methyl-n-butyl group, a 3-methyl-n-butyl group, a 1,1-dimethyl-n-propyl group, a 2,2-dimethyl-n-propyl group, a 1,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 2,2-dimethyl-n-butyl group, a 3,3-dimethyl-n-butyl group, a 1,2-dimethyl-n-butyl group, a 1,3-dimethyl-n-butyl group, a 2,3-dimethyl-n-butyl group, a 1-ethyl-n-butyl group, a 2-ethyl-n-butyl group, and a 1-(isopropyl)-n-propyl group.

Examples of the "cycloalkylene group having 3 to 8 carbon atoms which may contain an alkyl group having 1 to 6 carbon atoms as a substituent group" include cyclopropylene, 2-methylcyclopropylene, cyclobutylene, 2,2-dimethylcyclobutylene, cyclopentylene, 2,3-dimethylcyclopentylene, cyclohexylene, 1,3,3-trimethylcyclohexylene, and cyclooctylene.

Examples of the "aromatic ring having 5 to 7 carbon atoms which may contain an alkyl group having 1 to 6 carbon atoms as a substituent group" include a six-membered aromatic ring such as phenylene, tolylene, and xylylene.

The "combined group thereof" means "a combined group of the divalent straight or branched chain alkylene group having 1 to 10 carbon atoms and the cycloalkylene group having 3 to 8 carbon atoms which may contain an alkyl group having 1 to 6 carbon atoms as a substituent group", "a combined group of the divalent straight or branched chain alkylene group having 1 to 10 carbon atoms and the aromatic ring having 5 to 7 carbon atoms which may contain an alkyl group having 1 to 6 carbon atoms as a substituent group", "a combined group of the cycloalkylene group having 3 to 8 carbon atoms which may contain an alkyl group having 1 to 6 carbon atoms as a substituent group and the aromatic ring having 5 to 7 carbon atoms which may contain an alkyl group having 1 to 6 carbon atoms as a substituent group" or "a combined group of the divalent straight or branched chain alkylene group having 1 to 10 carbon atoms, the cycloalkylene group having 3 to 8 carbon atoms which may contain an alkyl group having 1 to 6 carbon atoms as a substituent group, and the aromatic ring having 5 to 7 carbon atoms which may contain an alkyl group having 1 to 6 carbon atoms as a substituent group".

Examples of the "combined group of the divalent straight or branched chain alkylene group having 1 to 10 carbon atoms and the cycloalkylene group having 3 to 8 carbon atoms which may contain an alkyl group having 1 to 6 carbon atoms as a substituent group" include a methylene-cyclopropylene group, a methylene-cyclopentylene group, a methylene-2,3-dimethylcyclopentylene group, a methylene-1,3,3,-trimethylcyclohexylene group, an ethylene-cyclopropylene group, an ethylene-cyclohexylene group, an ethylene-3,3-dimethylcyclohexylene group, a methylene-cyclopropylene-methylene group, an ethylene-cyclohexylene-methylene group, and a hexylene-cyclohexylene-methylene group. Also, the group combined in a different order can be used.

Examples of the "combined group of the divalent straight or branched chain alkylene group having 1 to 10 carbon atoms and the aromatic ring having 5 to 7 carbon atoms which may contain an alkyl group having 1 to 6 carbon atoms as a substituent group" include a methylene-phenylene group, a methylene-tolylene group, an ethylene-phenylene group, a hexylene-phenylene group, and a methylene-phenylene-ethylene group. Also, the group combined in a different order can be used.

Examples of the "combined group of the cycloalkylene group having 3 to 8 carbon atoms which may contain an alkyl group having 1 to 6 carbon atoms as a substituent group and the aromatic ring having 5 to 7 carbon atoms which may contain an alkyl group having 1 to 6 carbon atoms as a substituent group" include a cyclopropylene-phenylene group, a cyclopropylene-tolylene group, a cyclohexylene-phenylene group, and a cyclopropylene-phenylene-cyclohexylene group. Also, the group combined in a different order can be used.

Examples of the "combined group of the divalent straight or branched chain alkylene group having 1 to 10 carbon atoms, the cycloalkylene group having 3 to 8 carbon atoms which may contain an alkyl group having 1 to 6 carbon atoms as a substituent group, and the aromatic ring having 5 to 7 carbon atoms which may contain an alkyl group having 1 to 6 carbon atoms as a substituent group" include a methylene-cyclopropylene-phenylene group, a methylene-cyclohexylene-phenylene group, and a hexylene-cyclopropylene-phenylene group. Also, the group combined in a different order can be used.

Examples of the (meth)acrylate represented by the formula (III) include hydroxymethyl (meth)acrylate, 2-hydroxyethyl (meth)acrylate, 3-hydroxy-n-propyl (meth)acrylate, 2-hydroxy-n-propy (meth)acrylate, 2-hydroxyisopropyl (meth)acrylate, 4-hydroxy-n-butyl acrylate, 2-hydroxy-n-butyl acrylate, 3-hydroxy-n-butyl acrylate, 5-hydroxy-n-pentyl (meth)acrylate, 2-hydroxy-n-pentyl (meth)acrylate, 3-hydroxy-n-pentyl (meth)acrylate, 4-hydroxy-n-pentyl (meth)acrylate, 2-hydroxycyclopropyl (meth)acrylate, 3-hydroxycyclopentyl (meth)acrylate, and 4-hydroxycyclohexyl (meth)acrylate.

The amount of the (meth)acrylate compound is in the range of 0.2 to 2 times mole with respect to the hydroxyl group in the polybutadiene having a hydroxyl group at a terminal produced in the step (i).

Examples of the diisocyanate compound represented by the formula (IV) include methyl diisocyanate, 1,2-ethanediyl diisocyanate, 1,3-propanediyl diisocyanate, 1,6-hexanediyl diisocyanate, 3-methyl-octane-1,8-diyl diisocyanate, 1,2-cyclopropanediyl diisocyanate, 1,3-cyclobutanediyl diisocyanate, 1,4-cyclohexanediyl diisocyanate, 1,3-cyclohexanediyl diisocyanate, isophorone diisocyanate, 4-methyl-cyclohexane-1,3-diyl-diisocyanate, 4,4-methylenebis(cyclohexyl isocyanate), 1,3-bis(2-isocyanate-2-propyl) benzene, 1,4-bis(2-isocyanate-2-propyl) benzene, 2,6-diisocyanate hexanoic acid, 1,3-bis(5-isocyanate-1,3,3-trimethylcyclohexyl)-5-((trimethylsilyl)imino)-2,4-imidazolidinedione, acetamide, N-(1,3-bis(5-isocyanate-1,3,3-trimethylcyclohexyl)-2,5-(dioxo-imidazolidine-4-ylidene))acetamide, 2-propeneamide, N-(1,3-bis(5-isocyanate-1,3,3-trimethylcyclohexyl)-2,5-(dioxo-imidazolidine-4-ylidene))-2-methyl-2-propeneamide, 2,6-diisocyanate hexanoic acid, trans-1,4-cyclohexane diisocyanate, hexamethylene diisocyanate, 1,3-bis(isocyanatemethyl) benzene, 1,12-diisocyanatedodecane, trimethylhexamethylene diisocyanate, 1,4-diisocyanatebutane, 1,3-bis(isocyanatemethyl)cyclohexane, 1,8-diisocyanateoctane, trimethyl-1,6-diisocyanatehexane, 1-(2-heptyl-6-(9-isocyanatenonyl)-3-pentyl-cyclohexyl)-9-isocyanate-nonane, 1,4-bis(isocyanatemethyl)cyclohexane, isocyanic acid xylene ester, 1,2-bis(isocyanatemethyl) benzene, ethyl ester L-lysine diisocyanate, methyl ester L-lysine diisocyanate, 1,2-phenylene diisocyanate, 1,3-phenylene diisocyanate, 1,4-phenylene diisocyanate, 3-chloro-1,2-benzene diisocyanate, 4-chloro-1,2-benzene diisocyanate, 5-chloro-1,2-benzene diisocyanate, 2-chloro-1,3-benzene diisocyanate, 4-chloro-1,3-benzene diisocyanate, 5-chloro-1,3-benzene diisocyanate, 2-chloro-1,4-benzene diisocyanate, 3-chloro-1,4-benzene diisocyanate, 3-methyl-1,2-benzene diisocyanate, 4-methyl-1,2-benzene diisocyanate, 5-methyl-1,2-benzene diisocyanate, 2-methyl-1,3-benzene diisocyanate, 4-methyl-1,3-benzene diisocyanate, 5-methyl-1,3-benzene diisocyanate, 2-methyl-1,4-benzene diisocyanate, 3-methyl-1,4-benzene diisocyanate, 3-methoxy-1,2-benzene diisocyanate, 4-methoxy-1,2-benzene diisocyanate, 5-methoxy-1,2-benzene diisocyanate, 2-methoxy-1,3-benzene diisocyanate, 4-methoxy-1,3-benzene diisocyanate, 5-methoxy-1,3-benzene diisocyanate, 2-methoxy-1,4-benzene diisocyanate, 3-methoxy-1,4-benzene diisocyanate, 3,4-dimethyl-1,2-benzene diisocyanate, 4,5-dimethyl-1,3-benzene diisocyanate, 2,3-dimethyl-1,4-benzene diisocyanate, 3-chloro-4-methyl-1,2-benzene diisocyanate, 3-methyl-4-chloro-1,2-benzene diisocyanate, 3-methyl-5-chloro-1,2-benzene diisocyanate, 2-chloro-4-methyl-1,3-benzene diisocyanate, 4-chloro-5-methoxy-1,3-benzene diisocyanate, 5-chloro-2-fluoro-1,3-benzene diisocyanate, 2-chloro-3-bromo-1,4-benzene diisocyanate, and 3-chloro-5-isopropoxy-1,4-benzene diisocyanate.

The amount of the diisocyanate compound is 0.2 to 2 times mole with respect to the hydroxyl group in the polybutadiene having a hydroxyl group at a terminal produced in the step (i).

In the adhesive composition of the present invention, the terminal acrylic-modified polybutadiene is contained in an amount preferably ranging from 1.0 to 80.0% by mass, desirably ranging from 5.0 to 50.0% by mass, based on the total amount of the composition.

In addition, the adhesive composition of the present invention may contain other additives as needed. Examples of the additive include a silane coupling agent such as vinyltrimethoxysilane, vinyltriethoxysilane, γ-glycidoxypropyltrimethoxysilane, γ-glycidoxypropyltriethoxysilane, γ-methacryloxypropyltrimethoxysilane, γ-methacryloxypropyltriethoxysilane, γ-aminopropyltrimethoxysilane, γ-aminopropyltriethoxysilane, N-β(aminoethyl) γ-aminopropyltrimethoxysilane, N-β(aminoethyl) γ-aminopropyltriethoxysilane, N-phenyl-γ-aminopropyltrimethoxysilane, N-phenyl-γ-aminopropyltriethoxysilane, γ-mercaptopropyltrimethoxysilane, and γ-mercaptopropyltriethoxysilane; a filler such as calcium bicarbonate, light calcium carbonate, natural silica, synthetic silica, molten silica, kaolin, clay, titanium oxide, barium sulphate, zinc oxide, aluminum hydroxide, magnesium hydroxide, talc, mica, wollastonite, potassium titanate, aluminum borate, sepiolite, and xonotlite; an elastomer modifier such as NBR, polybutadiene, chloroprene rubber, silicone, cross-linked NBR, cross-linked BR, acrylics, core-shell acrylic, urethane rubber, polyester elastomer, liquid NBR having a functional group, liquid polybutadiene, liquid polyester, liquid polysulfide, modified silicone, and an urethane prepolymer;
a flame retardant such as hexabromocyclodecane, bis(dibromopropyl)tetrabromobisphenol A, tris(dibromopropyl)isocyanurate, tris(tribromoneopentyl) phosphate, decabromodiphenyl oxide, bis(pentabromo)phenylethane, tris(tribromophenoxy)triazine, ethylenebistetrabromophthalimide, polybromophenylindan, brominated polystyrene, tetrabromobisphenol A polycarbonate, brominated phenyleneethylene oxide, polypentabromobenzyl acrylate, triphenyl phosphate, tricresyl phosphate, trixylenyl phosphate, cresyldiphenyl phosphate, xylyldiphenyl phosphate, cresylbis(di-2,6-xylenyl) phosphate, 2-ethylhexyldiphenyl phosphate, resorcinol bis(diphenyl) phosphate, bisphenol A bis(diphenyl) phosphate, bisphenol A bis(dicresyl) phosphate, resorcinol bis(di-2,6-xylenyl) phosphate, tris(chloroethyl) phosphate, tris(chloropropyl) phosphate, tris(dichloropropyl) phosphate, tris(tribromopropyl) phosphate, diethyl-N,N-bis(2-hydrooxyethyl)aminomethyl phosphonate, anionic oxalic acid treated aluminum hydroxide, nitrate salt treated aluminum hydroxide, high-temperature hot water treated aluminum hydroxide, stannic acid surface treated hydrated metal compound, nickel compound surface treated magnesium hydroxide, silicone polymer surface treated magnesium hydroxide, procobite, multi-layer surface treated hydrated metal compound, and cation polymer treated magnesium hydroxide; an engineering plastic such as high density polyethylene, polypropylene, polystyrene, polymethyl methacrylate, polyvinyl chloride, nylon 6,6, polyacetal, polyethersulphone, polyetherimide, polybutylene terephtalate, polyether ether ketone, polycarbonate, and polysulphone; a plasticizer; a diluent such as n-butyl glycidyl ether, phenyl glycidyl ether, styrene oxide, t-butylphenyl glycidyl ether, dicyclopentadiene diepoxide, phenol, cresol, and t-butylphenol; an extender; a strengthening agent; a coloring agent; a viscosity improver; a mold release agent such as a higher fatty acid, a higher fatty acid ester, and a higher fatty acid calcium, including carnauba wax and polyethylene wax. The compounding amount of these additives is not particularly limited, and the compounding amount can be appropriately determined within the limit that the effect of the present invention may be obtained.

Furthermore, an additive contained in an adhesive consisting of an ordinary thermosetting resin can be added. Examples of such an additive include a thixotropy imparting agent; an inorganic ion exchanger; an anti-bleeding agent; an adhesive imparting agent.

The adhesive composition of the present invention can be produced by mixing the above components. Examples of the mixing method include, but are not limited to, a method using a pot mill, a ball mill, a bead mill, a roll mill, a homogenizer, a super mill, a homodisper, a universal mixer, a Banbury mixer, or a kneader, and a method of dissolving the components in an appropriate solvent such as chloroform, tetrachloroethylene, methyl ethyl ketone, toluene, ethyl acetate, tetrahydrofuran, hexane, and cyclohexane and mixing them.

### Examples

A description will now be given of Examples of the present invention, but it should be construed that the invention is in no way limited to those Examples.

In the following Examples, butadiene means 1,3-butadiene. THF means tetrahydrofuran, and n-Hex means n-hexane.

### 1 Production of polybutadiene

### (Example 1)

212 g of n-hexane was put into a 1 L flask and cooled to -40°C. 23 g of a n-hexane solution of n-butyllithium (the content was 15.4% by mass), and then, 48 g of a THF solution of potassium t-butoxide (the content of potassium t-butoxide was 12.4% by mass, which was an equimolar amount of that of n-butyllithium) were added, and stirred at -40°C for 30 minutes. 14 g of butadiene liquefied at -78°C was added dropwise to the above solution, and then, stirred at -20°C for 1 hour. Further, 35 g of the liquefied butadiene was added dropwise, and then, stirred at -20°C for 1 hour. Next, 17 g of methanol was added.

The resultant solution was washed by 200 g of pure water twice, and then, washed by 200 g of 0.2% hydrochloric acid aqueous solution three times. After that, the resultant solution was diluted by 180 g of toluene, and then, washed by 300 g of pure water four times. An organic layer was concentrated and the solvent was distilled away, thus obtaining 48 g of a liquid resin.

Physical properties of the obtained resin were as follows.
microstructure ratio (% by mole), 1,4-structure/1,2-structure = 41.5/58.5
Mn by GPC = 2,109, Mw/Mn = 1.09
Mn by ¹H-NMR calculation = 1,397

### (Example 2)

278 g of THF was put into a 1 L flask, and 2.7 g of a sodium dispersion (a metal sodium dispersion in kerosene, the content was 43.7%) was added at room temperature, and then, cooled to -40°C. Next, 44 g of a THF solution of potassium t-butoxide (the content of potassium t-butoxide was 12.4% by mass, which was an equimolar amount of that of sodium) was added, and then, stirred at -40°C for 30 minutes. Next, 7 g of liquefied butadiene was added. After the resultant solution was stirred at -20°C for 1 hour, 42 g of liquefied butadiene was added. Further, the resultant solution was stirred at -20°C for 2 hours, and then, 16 g of methanol was added.

The resultant solution was poured into 1480 g of methanol, a supernatant was removed by decantation, and a syrupy precipitate was dissolved in 162 g of toluene. The resultant solution was washed by 150 g of pure water once, washed by 150 g of 0.2% hydrochloric acid aqueous solution once, and then, washed by 300 g of pure water three times. An organic layer was concentrated and the solvent was distilled away, thus obtaining 49 g of a viscid liquid resin.

Physical properties of the obtained resin were as follows.
Microstructure ratio (% by mole), 1,4-structure/1,2-structure = 26.6/73.4
Mn by GPC = 3578, Mw/Mn = 1.29

### (Example 3)

196 g of THF was put into a 1 L flask and cooled to -40°C. 23 g of a n-hexane solution of n-butyllithium (the content was 15.4% by mass), and then, 91 g of a THF solution of potassium t-butoxide (the content of potassium t-butoxide was 12.4% by mass, which was twice an equimolar amount of that of n-butyllithium) were added, and stirred at -40°C for 30 minutes. 14 g of butadiene liquefied at - 78°C was added dropwise to the above solution, and then, stirred at -20°C for 30 minutes. Further, 35 g of the liquefied butadiene was added dropwise, and stirred at - 20°C for 1 hour. Next, 17 g of methanol was added.

The resultant solution was washed by 300 g of pure water once, washed by 200 g of 0.1% hydrochloric acid aqueous solution once, and then, washed by 200 g of pure water twice. An organic layer was concentrated and the solvent was distilled away, and then, diluted by 90 g of THF. The resultant solution was poured into 840 g of methanol, a supernatant was removed by decantation, and a syrupy precipitate was dissolved in 100 g of THF. The resultant solution was concentrated and the solvent was distilled away, thus obtaining 46 g of a liquid resin.

Physical properties of the obtained resin were as follows.
Microstructure ratio (% by mole), 1,4-structure/1,2-structure = 30.2/69.8
Mn by GPC = 6,172, Mw/Mn = 1.08
Mn by ¹H-NMR calculation = 3,368

### (Example 4)

420 g of n-hexane was put into a 1 L flask and cooled to -40°C. 21 g of a n-hexane solution of n-butyllithium (the content was 15.4% by mass), and then, 35 g of a THF solution of potassium t-butoxide (the content of potassium t-butoxide was 12.4% by mass, which was an equimolar amount of that of n-butyllithium) were added, and stirred at -40°C for 30 minutes. 105 g of butadiene liquefied at -78°C was added dropwise to the above solution, and then, stirred at -20°C for 1.5 hours. Next, 16 g of methanol was added.

The resultant solution was washed by 300 g of 0.1% hydrochloric acid aqueous solution twice and washed by 300 g of pure water four times. An organic layer was concentrated and the solvent was distilled away, and then, diluted by 190 g of THF. The resultant solution was poured into 2270 g of methanol, a supernatant was removed by decantation, and a syrupy precipitate was dissolved in 280 g of THF. The resultant solution was concentrated and the solvent was distilled away, thus obtaining 105 g of a liquid resin.

Physical properties of the obtained resin were as follows.
Microstructure ratio (% by mole), 1,4-structure/1,2-structure = 39.5/60.5
Mn by GPC = 4,195, Mw/Mn = 1.05
Mn by ¹H-NMR calculation = 2,563

### (Comparative Example 1)

400 g of THF and 130 g of n-hexane were put into a 1 L flask, and then, cooled to -40°C. To the above solution, 52 g of a n-hexane solution of n-butyllithium (the content was 15.4% by mass) was added, and then, 130 g of butadiene liquefied at -78°C was added dropwise. After the resultant solution was stirred at -20°C for 1 hour, 46 g of methanol was added.

The resultant solution was washed by 300 g of 0.2% hydrochloric acid aqueous solution twice and then washed by 300 g of pure water three times. 11 g of anhydrous magnesium sulphate was added to an organic layer, and then, left at rest for 30 minutes. Filtration was performed and an obtained filtrate was concentrated. After that, the solvent was distilled away, thus obtaining 146 g of a highly viscous liquid resin.

Physical properties of the obtained resin were as follows.
Microstructure ratio (% by mole), 1,4-structure/1,2-structure = 8.2/91.8
Mn by GPC = 1,975, Mw/Mn = 1.05
Mn by ¹H-NMR calculation = 1,088

### (Comparative Example 2)

432 g of THF was put into a 1 L flask and cooled to -40°C. 5.8 g of a sodium dispersion (a metal sodium dispersion in kerosene, the content was 43.7%) was added, and then, 14 g of liquefied butadiene was added. After the above solution was stirred at -20°C for 2 hours, 91 g of liquefied butadiene was added. Further, the resultant solution was stirred at -20°C for 2 hours, and then, 34 g of methanol was added. 200 g of n-hexane was added to the resultant solution, and then, washed by 300 g of pure water twice, washed by 300 g of 0.2% hydrochloric acid aqueous solution once, and washed by 300 g of pure water three times. 10 g of anhydrous magnesium sulphate was added to an organic layer, and then, left at rest for 30 minutes. Filtration was performed and an obtained filtrate was concentrated. After that, the solvent was distilled away, thus obtaining 105 g of a highly viscous liquid resin.

Physical properties of the obtained resin were as follows.
Microstructure ratio (% by mole), 1,4-structure/1,2-structure = 13.9/86.1
Mn by GPC = 2,738, Mw/Mn = 1.39

### (Comparative Example 3)

377 g of THF was put into a 1 L flask, and 3.2 g of a sodium potassium alloy (Na/K = 22/78, by mass ratio) was added at room temperature, and then, cooled to -20°C. 18 g of liquefied butadiene was added, and then, stirred at - 20°C for 1 hour. Next, 42 g of liquefied butadiene was added, and stirred at -20°C for 1 hour and then at -10°C for 1 hour. After that, 63 g of methanol was added gradually.

300 g of n-hexane was added to the resultant solution, and then, washed by 500 g of pure water twice, washed by 500 g of 0.1% hydrochloric acid aqueous solution four times, and washed by 500 g of pure water once. An organic layer was concentrated, and diluted by 130 g of THF and 100 g of toluene. Then, the resultant solution was washed by 300 g of 0.2% hydrochloric acid aqueous solution twice, and then, washed by 300 g of pure water three times. An organic layer was concentrated and the solvent was distilled away, thus obtaining 60 g of a highly viscous liquid resin.

Physical properties of the obtained resin were as follows.
Microstructure ratio (% by mole), 1,4-structure/1,2-structure = 26.6/73.4
Mn by GPC = 16,217, Mw/Mn = 1.33

### (Comparative Example 4)

338 g of n-hexane was put into a 1 L flask and cooled to -40°C. To the resultant solution, 56 g of a cyclohexane solution of sec-butyllithium (the content was 10.6% by mass) was added, and then, 84 g of butadiene liquefied at -78°C was added dropwise. The above solution was stirred at -20°C for 2 hours. A sample was taken from the resultant polymer liquid and measured by GPC. The GPC measurement indicated that no polymer was generated. Next, 18 g of THF was added to the polymer liquid, and then, stirred at -20°C for 30 minutes. A sample was taken from the resultant polymer liquid and measured by GPC. The GPC measurement indicated generation of a polymer. Further, after 1.5 hours, 30 g of methanol was added.

The resultant solution was washed by 300 g of 0.3% hydrochloric acid aqueous solution twice, and then, washed by 300 g of pure water twice. 11 g of anhydrous magnesium sulphate was added to an organic layer, and then, left at rest for 30 minutes. Filtration was performed and an obtained filtrate was concentrated. After that, the solvent was distilled away, thus obtaining 89 g of a highly viscous liquid resin.

Physical properties of the obtained resin were as follows.
Microstructure ratio (% by mole), 1,4-structure/1,2-structure = 8.1/91.9
Mn by GPC = 1,496, Mw/Mn = 1.07
Mn by ¹H-NMR calculation = 852

### (Examples 5 to 7)

A polybutadiene was produced by the same process as that in Example 1 except that the amount of potassium t-butoxide (t-BuOK) with respect to the polymerization initiator (n-BuLi) was changed (Examples 5-7).

With the results of Example 1 and Comparative Example 4, the results are shown in Table 1.

**[Table 1]**

| Example | Type of solvent | | Ratio of solvent | | t-BuOK | Microstructure | | Molecular weight (GPC method | |
|---|---|---|---|---|---|---|---|---|---|
| | Solvent ① | Solvent ② | Solvent ① | Solvent ② | (Equivalent amount) | 1,4- | 1,2- | Mn | Mw/Mn |
| Comparative Example 4 | n-Hex | THF | 100 | 5 | 0 | 8.1 | 91.9 | 1496 | 1.066 |
| Example 5 | n-Hex | THF | 91 | 9 | 0.25 | 24.5 | 75.5 | 1554 | 1.078 |
| Example 6 | n-Hex | THF | 91 | 9 | 0.5 | 37.5 | 62.5 | 1882 | 1.077 |
| Example 1 | n-Hex | THF | 83 | 17 | 1 | 41.5 | 58.5 | 2109 | 1.089 |
| Example 7 | n-Hex | THF | 70 | 30 | 2 | 38.5 | 61.5 | 7465 | 1.053 |

### 2 Production of composition and evaluation

### (Example 8)

Components shown in the following Table were mixed at a mass ratio shown in the Table, and then, dissolved in cyclohexane so that the content of a nonvolatile component became 20% by mass.

**[Table 2]**

| Name of product | Mass ratio |
|---|---|
| Thermoplastic elastomer (Kraton D-1101JS) | 55 |
| 1,6-Hexanediol diacrylate | 30 |
| Benzyl methyl ketal | 3 |
| BHT | 1.9 |
| Butadiene produced in Example 4 | 10 |

| | |
|---|---|
| *Note that Kraton D-1101JS is a styrene-butadiene-styrene block polymer manufactured by Kraton Polymers. Note that BHT represents dibutylhydroxytoluene. | |

The cyclohexane solution obtained in Example 8 was air-dried in an aluminum cup overnight, and then, dried with heat at 50°C for 5 hours.

Light was irradiated using an ultrahigh pressure mercury lamp of 10 mW so that an integrated light quantity became about 6000 mJ/cm².

A resultant photo-cured film was peeled off from the aluminum cup, and a test piece having a length of 25 mm and a width of 5 mm was cut out. The thickness of the film was 0.8 mm.

The test piece was subjected to a tensile test using SHIMADZU Autograph (AGS-J). The test was performed under the conditions of the distance between chucks of 20 mm and the test speed of 20 mm/minute, and the elastic modulus was calculated. The result is shown in the following

Table.

### (Comparative Example 5)

A composition was prepared by the same process as that in Example 8 except that B-1000 was used instead of the polybutadiene produced in Example 4, and a test was performed by the same process.

**[Table 3]**

| | | Example 8 | Comparative Example 5 |
|---|---|---|---|
| Polybutadiene | | Polybutadiene produced in Example 4 | B-1000 |
| Microstructure | 1,4 (mol%) | 39.5 | 17.4 |
| | 1,2 (mol%) | 60.5 | 82.6 |
| Tg(°C) | | -58 | -44 |
| Viscosity (cP, 45°C) | | 918 | 960 |
| Molecular weight (GPC) | Mn | 4195 | 2485 |
| Molecular weight distribution | Mw/Mn | 1.046 | 1.404 |
| Elastic modulus (MPa) | | 123 | 75 |
| Maximum stress (MPa) | | 8.4 | 6.8 |
| Maximum strain (%) | | 41 | 47 |

| | | | |
|---|---|---|---|
| *Note that B-1000 is a polybutadiene manufactured by NIPPON SODA CO., LTD. | | | |

### (Example 9)

### (Production of polybutadiene added by ethylene oxide at terminal)

453 g of tetrahydrofuran (THF) was put into a reaction vessel, and 5.4 g of a sodium dispersion (a dispersion in kerosene having a content of 44.0%) was added at room temperature. After the above solution was cooled to -40°C, 91 g of potassium t-butoxide (a THF solution having a content of 12.4% by mass) was added, and stirred at -40°C for 30 minutes. Then, 18 g of liquefied butadiene was added. After the resultant solution was stirred at -20°C for 1 hour, 70 g of liquefied butadiene was added. Further, the resultant solution was stirred at -20°C for 2 hours, and then, 21 g of liquefied butadiene was added. After the resultant solution was stirred at-20°C for 1.5 hours, 125 mL of ethylene oxide (1.1 M, a THF solution) was added. The temperature of the reaction solution was elevated to room temperature and the reaction solution was stirred for 40 minutes. After that, 122 g of methanol was added. The resultant solution was poured into methanol, a supernatant was removed by decantation, and a syrupy precipitate was dissolved in hexane. The resultant solution was washed by 0.2% hydrochloric acid aqueous solution and then washed by pure water. After an organic layer was concentrated, the solvent was distilled away, thus obtaining 103 g of a polybutadiene added by ethylene oxide at the terminals.

Physical properties of the obtained polybutadiene having ethylene oxide added at the terminals were as follows.

A microstructure ratio (% by mole), 1,4-structure/1,2-structure = 25.4/74.6, GPC measurement (polystyrene standard) indicated that Mn = 4,983 and Mw/Mn = 1.24 with RI detection. In ¹H-NMR spectrum, it was confirmed that a signal derived from a hydroxyethyl group generated by ring-opening addition of ethylene oxide appeared at 3.6 ppm. A molecular weight calculated from an integral value thereof was 3223. It is empirically known that about 60% of the molecular weight measured by GPC (polystyrene standard) is the molecular weight corresponding to a polybutadiene. Based on the molecular weights measured by GPC and ¹H-NMR, a rate of modification by ethylene oxide (a rate of introduction of a hydroxyl group at the terminals) was 90%. In addition, a hydroxyl value (OHV) was 39.0 KOHmg/g.

### (Production of terminal acrylic-modified polybutadiene 1)

7.14 g of tolylene diisocyanate (manufactured by Mitsubishi Chemical Corporation, Cosmonate T-80), 5.08 g of 2-hydroxyethyl methacrylate, 85.0 g of the polybutadiene added by ethylene oxide at a terminal, 0.06 g of butylhydroxytoluene (hereinafter, abbreviated as "BHT") were put into a reaction vessel, and a terminal acrylic-modified polybutadiene 1 (in the formula (I), R¹ = -CH₂CH₂-, R² = tolylene, R³ = -CH₂CH₂-, R⁴ = CH₃) was produced by a known method. The amount of NCO (the amount of an isocyanate group by weight percent) in the reactant was measured and the result was that the amount was less than 0.1%.

### (Comparative Example 6)

### (Production of terminal acrylic-modified polybutadiene 2)

A terminal acrylic-modified polybutadiene 2 (in the formula (I), R¹ = -CH₂CH₂-, R² = tolylene, R³ = -CH₂CH₂-, R⁴ = CH₃) was produced by the same process as that of the terminal acrylic-modified polydiene 1 except that polybutadiene Poly bd R45HT (manufactured by Idemitsu Kosan Co., Ltd.) having hydroxyl groups at both terminals was used instead of the "polybutadiene added by ethylene oxide at the terminals".

It is noted that the Poly bd R45HT (manufactured by Idemitsu Kosan Co., Ltd.) used in the reaction had the following physical properties.
Microstructure ratio (% by mole), 1,4-structure/1,2-structure = 80.0/20.0
GPC measurement (polystyrene standard) indicated that Mn = 4,942 and Mw/Mn = 2.28 with RI detection. In addition, a hydroxyl value (OHV) was 44.9 mgKOH/g.

### (Evaluation test for two-component adhesive)

### (Preparation of test solution A-1)

50 parts of NISSO-PB TE-2000 (manufactured by NIPPON SODA CO., LTD.), 50 parts of methyl methacrylate (hereinafter, abbreviated as MMA), 4 parts of cumene hydroperoxide (manufactured by NOF Corporation, product name: Percumyl H-80), and 0.8 parts of dimethyltoluidine were mixed, thus obtaining a test solution A-1.

NISSO-PB TE-2000 manufactured by NIPPON SODA CO., LTD. was a terminal acrylic-modified polybutadiene having the following physical properties.
microstructure ratio (% by mole), 1,4-structure/1,2-structure = 14.0/86.0
GPC measurement (polystyrene standard) indicated that Mn = 5,354 and Mw/Mn = 1.72, with RI detection.

### (Preparation of test solution A-2)

A test solution A-2 was obtained by the same process as that of the test solution A-1 except that NISSO-PB TE-2000 (manufactured by NIPPON SODA CO., LTD.) was replaced by the polybutadiene 1 produced in Example 9.

### (Preparation of test solution A-3)

A test solution A-3 was obtained by the same process as that of the test solution A-1 except that NISSO-PB TE-2000 (manufactured by NIPPON SODA CO., LTD.) was replaced by the polybutadiene 2 produced in Comparative Example 6.

### (Preparation of test solution B-1)

50 parts of NISSO-PB TE-2000 (manufactured by NIPPON SODA CO., LTD.), 50 parts of MMA, 1 part of cobalt naphthenate were mixed, thus obtaining a test solution B-1.

### (Preparation of test solution B-2)

A test solution B-2 was obtained by the same process as that of the test solution B-1 except that NISSO-PB TE-2000 (manufactured by NIPPON SODA CO., LTD.) was replaced by the polybutadiene 1 produced in Example 9.

### (Preparation of test solution B-3)

A test solution B-3 was obtained by the same process as that of the test solution B-1 except that NISSO-PB TE-2000 (manufactured by NIPPON SODA CO., LTD.) was replaced by the polybutadiene 2 produced in Comparative Example 6.

**[Table 4]**

| | Composition of test solution A | | | Composition of test solution B | | |
|---|---|---|---|---|---|---|
| | A-1 | A-2 | A-3 | B-1 | B-2 | B-3 |
| TE-2000 | 50 Parts | - | - | 50 Parts | - | - |
| Polybutadiene 1 | - | 50 Parts | - | - | 50 Parts | - |
| Polybutadiene 2 | - | - | 50 Parts | - | - | 50 Parts |
| MMA | 50 Parts | 50 Parts | 50 Parts | 50 Parts | 50 Parts | 50 Parts |
| Cumene hydroperoxide | 4 Parts | 4 Parts | 4 Parts | - | - | - |
| Dimethyltolui dine | 0.8 Part | 0.8 Part | 0.8 Part | - | - | - |
| Cobalt naphthenate | - | - | - | 1 Part | 1 Part | 1 Pa rt |

### (Evaluation test of tensile shear strength)

The prepared test solutions A-1 to A-3 and the test solutions B-1 to B-3 were each applied onto a tin plate having a width of 5 cm. The tin plates coated with the test solutions A-1 and B-1 were superimposed on each other and bonded so that the superimposed portion became 1 cm. Similarly, the tin plates coated with the test solutions A-2 and B-2 were bonded to each other. After the tin plates were left at rest at 25°C for 24 hours, the tensile shear strengths were measured using a tensile testing machine (SHIMADZU Autograph AGS-J 5kN, with pulling chucks) (measurement temperature: 25°C, test speed: 0.5 mm/minutes).

In the case of compositions of the test solutions A-3 and B-3, the test solutions were gelled at room temperature and could not be applied, and therefore, a test for combination of A-3 and B-3 was not performed.

**[Table 5]**

| Test solution A | Test solution B | Shear strength (MPa) |
|---|---|---|
| A-1 | B-1 | 58.8 |
| A-2 | B-2 | 71.2 |
| A-3 | B-3 | - |

### (Evaluation test for photo-curable adhesive)

### (Preparation of composition C-1)

60 parts of NISSO-PB TE-2000 (manufactured by NIPPON SODA CO., LTD.), 40 parts of tricyclodecanyl diacrylate, 20 parts of n-butyl acrylate, 1 part of 2,2-dimethoxy-2-phenylacetophenone and 0.1 parts of BHT were mixed, thus obtaining a composition C-1.

### (Preparation of composition C-2)

A test solution C-2 was obtained by the same process as that of the test solution C-1 expect that NISSO-PB TE-2000 (manufactured by NIPPON SODA CO., LTD.) was replaced by the polybutadiene 1 produced in Example 9.

### (Preparation of composition C-3)

A test solution C-3 was obtained by the same process as that of the test solution C-1 expect that NISSO-PB TE-2000 (manufactured by NIPPON SODA CO., LTD.) was replaced by the polybutadiene 1 produced in Comparative Example 6.

### (Evaluation test of tensile shear strength)

Compositions C-1 to C-3 were each applied onto a 2.5 cm-square glass plate (product name Tepax, having a thickness of 2 mm) using a bar coater No. 4. Another glass plate was superimposed on the glass plate and bonded so that the superimposed length became 1 cm, and then irradiated with light. The light irradiation was performed at a light intensity of 13 mW/cm² for 5 seconds using a SPOTCURE SP-V manufactured by USHIO Inc. The tensile shear strengths were measured using a tensile testing machine (SHIMADZU Autograph AGS-J 5kN, with pulling chucks) (measurement temperature: 25°C, test speed: 10 mm/minute).

**[Table 6]**

| | Composition of composition C | | |
|---|---|---|---|
| | C-1 | C-2 | C-3 |
| TE-2000 | 60 Parts | - | - |
| Polybutadiene 1 | - | 60 Parts | - |
| Polybutadiene 2 | - | - | 60 Parts |
| Tricyclodecanyl diacrylate | 40 Parts | 40 Parts | 40 Parts |
| n-Butyl acrylate | 20 Parts | 20 Parts | 20 Parts |
| 2,2-Dimethoxy-2-phenylacetophenone | 1 Part | 1 Part | 1 Part |
| BHT | 0.1 Part | 0.1 Part | 0.1 Part |
| Tensile shear strength (MPa) | 8.7 | 11.2 | 9.3 |

The composition using the polybutadiene 1 produced in Example 9 exhibited higher shear strengths in comparison with the cases where other acrylic modified polybutadienes were used, in the evaluations of the two-pack adhesive and the photo-curable adhesive.

## Claims

1. A method for producing a polybutadiene by anionic polymerization of 1,3-butadiene in the presence of a polymerization initiator and under the conditions of a reaction temperature not higher than the boiling point of butadiene, wherein the polymerization is carried out in the presence of a potassium salt in an aprotic polar solvent or in a mixed solvent of an aprotic polar solvent and a nonpolar solvent.

2. The method for producing a polybutadiene according to claim 1, wherein the potassium salt is potassium t-butoxide.

3. The method for producing a polybutadiene according to claim 1 or 2, wherein the mixed solvent of an aprotic polar solvent and a nonpolar solvent is a mixed solvent of tetrahydrofuran and hexane.

4. A polybutadiene produced by the method according to any one of claims 1 to 3, having a microstructure ratio of 1,2-structure/1,4-structure ranging from 55/45 to 80/20 (% by mole) and having a molecular weight distribution ranging from 1.01 to 1.30.

5. A plate-making material composition for flexographic printing, comprising:
(A) 50 to 90% by mass of a thermoplastic elastomer;
(B) 5 to 40% by mass of the polybutadiene produced by the method according to any one of claims 1 to 3;
(C) 1 to 30% by mass of an ethylenically unsaturated compound; and
(D) 0.1 to 3% by mass of a photopolymerization initiator, and
exhibiting an elastic modulus ranging from 80 to 150 MPa after being cured by light.

6. The plate-making material composition for flexographic printing according to claim 5, wherein the thermoplastic elastomer is a styrene-butadiene-styrene block polymer and/or a styrene-isoprene-styrene block polymer.

7. An adhesive composition comprising a terminal acrylic-modified polybutadiene derived from the polybutadiene produced by the method according to any one of claims 1 to 3.

8. The adhesive composition according to claim 7, wherein the terminal acrylic-modified polybutadiene is represented by formula (I): 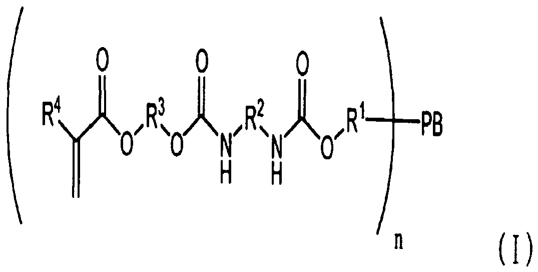 (wherein R¹ to R³ each independently represent a divalent straight or branched chain alkylene group having 1 to 10 carbon atoms, a cycloalkylene group having 3 to 8 carbon atoms which may contain an alkyl group having 1 to 6 carbon atoms as a substituent group, an aromatic ring having 5 to 7 carbon atoms which may contain an alkyl group having 1 to 6 carbon atoms as a substituent group, or a combined group thereof; R⁴ represents a hydrogen atom or a methyl group; PB represents the polybutadiene produced by the method according to any one of claims 1 to 3; and n represents 1 or 2).

## Patentansprüche

1. Verfahren zur Herstellung eines Polybutadiens durch anionische Polymerisation von 1,3-Butadien in Gegenwart eines Polymerisationsinitiators und unter den Bedingungen einer Reaktionstemperatur, die nicht höher ist als der Siedepunkt von Butadien, wobei die Polymerisation in Gegenwart eines Kaliumsalzes in einem aprotischen polaren Lösungsmittel oder in einem Lösungsmittelgemisch aus einem aprotischen polaren Lösungsmittel und einem apolaren Lösungsmittel erfolgt.

2. Verfahren zur Herstellung eines Polybutadiens nach Anspruch 1, wobei das Kaliumsalz Kalium-t-butoxid ist.

3. Verfahren zur Herstellung eines Polybutadiens nach Anspruch 1 oder 2, wobei das Lösungsmittelgemisch aus einem aprotischen polaren Lösungsmittel und einem apolaren Lösungsmittel ein Lösungsmittelgemisch aus Tetrahydrofuran und Hexan ist.

4. Polybutadien, das mit dem Verfahren nach einem der Ansprüche 1 bis 3 hergestellt ist, mit einem Mikrostrukturverhältnis von 1,2-Struktur zu 1,4-Struktur im Bereich von 55 : 45 bis 80 : 20 (Mol-%) und mit einer Molekulargewichtsverteilung im Bereich von 1,01 bis 1,30.

5. Plattenherstellungsmaterial-Zusammensetzung für den Flexodruck, die umfasst:
(A) 50 bis 90 Masse% eines thermoplastischen Elastomers;
(B) 5 bis 40 Masse% des mit dem Verfahren nach einem der Ansprüche 1 bis 3 hergestellten Polybutadiens;
(C) 1 bis 30 Masse% einer ethylenisch ungesättigten Verbindung; und
(D) 0,1 bis 3 Masse% eines Photopolymerisationsinitiators, und
nach Lichthärtung einen Elastizitätsmodul im Bereich von 80 bis 150 MPa aufweist.

6. Plattenherstellungsmaterial-Zusammensetzung für den Flexodruck nach Anspruch 5, wobei das thermoplastische Elastomer ein Styren-Butadien-Styren-Blockpolymer und/oder ein Styren-Isopren-Styren-Blockpolymer ist.

7. Klebstoffzusammensetzung, umfassend ein Polybutadien mit acrylmodifizierter Endgruppe, das von dem mit dem Verfahren nach einem der Ansprüche 1 bis 3 hergestellten Polybutadien abgeleitet ist.

8. Klebstoffzusammensetzung nach Anspruch 7, wobei das Polybutadien mit acrylmodifizierter Endgruppe durch die Formel (I) dargestellt ist: 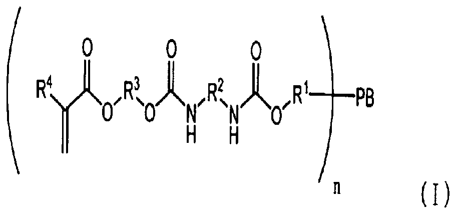 (wobei R¹ bis R³ jeweils unabhängig für eine zweiwertige gerad- oder verzweigtkettige Alkylengruppe mit 1 bis 10 Kohlenstoffatomen, eine Cycloalkylengruppe mit 3 bis 8 Kohlenstoffatomen, die eine Alkylgruppe mit 1 bis 6 Kohlenstoffatomen als Substituent enthalten kann, einen aromatischen Ring mit 5 bis 7 Kohlenstoffatomen, der eine Alkylgruppe mit 1 bis 6 Kohlenstoffatomen als Substituent enthalten kann, oder eine kombinierte Gruppe aus denselben stehen; R⁴ für ein Wasserstoffatom oder eine Methylgruppe steht; PB für das mit dem Verfahren nach einem der Ansprüche 1 bis 3 hergestellte Polybutadien steht; und n für 1 oder 2 steht).

## Revendications

1. Procédé de production d'un polybutadiène par polymérisation anionique de 1,3-butadiène en présence d'un initiateur de polymérisation et dans les conditions d'une température de réaction pas supérieure au point d'ébullition du butadiène, dans lequel la polymérisation est réalisée en présence d'un sel de potassium dans un solvant polaire aprotique ou dans un solvant mixte d'un solvant polaire aprotique et d'un solvant non polaire.

2. Procédé de production d'un polybutadiène selon la revendication 1, dans lequel le sel de potassium est le t-butoxyde de potassium.

3. Procédé de production d'un polybutadiène selon la revendication 1 ou la revendication 2, dans lequel le solvant mixte d'un solvant polaire aprotique et d'un solvant non polaire est un solvant mixte de tétrahydrofurane et d'hexane.

4. Polybutadiène produit par le procédé selon l'une quelconque des revendications 1 à 3, ayant un rapport de microstructure de structure 1,2/structure 1,4 dans la plage de 55/45 à 80/20 (% en moles) et ayant une distribution de la masse moléculaire dans la plage de 1,01 à 1,30.

5. Composition de matière de fabrication de plaques pour impression flexographique, comprenant :
(A) de 50 à 90 % en masse d'un élastomère thermoplastique ;
(B) de 5 à 40 % en masse du polybutadiène produit par le procédé selon l'une quelconque des revendications 1 à 3 ;
(C) de 1 à 30 % en masse d'un composé éthyléniquement insaturé ; et
(D) de 0,1 à 3 % en masse d'un initiateur de photopolymérisation, et
présentant un module d'élasticité dans la plage de 80 à 150 MPa après durcissement par la lumière.

6. Composition de matière de fabrication de plaques pour impression flexographique selon la revendication 5, dans laquelle l'élastomère thermoplastique est un polymère séquencé styrène/butadiène/styrène et/ou un polymère séquencé styrène/isoprène/styrène.

7. Composition adhésive comprenant un polybutadiène à modification terminale acrylique dérivé du polybutadiène produit par le procédé selon l'une quelconque des revendications 1 à 3.

8. Composition adhésive selon la revendication 7, dans laquelle le polybutadiène à modification terminale acrylique est représenté par la formule (I) : 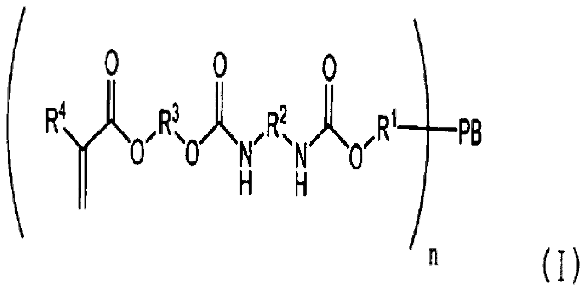 (dans laquelle R¹ à R³ représentent chacun indépendamment un groupe alkylène divalent à chaîne linéaire ou ramifiée ayant de 1 à 10 atomes de carbone, un groupe cycloalkylène ayant de 3 à 8 atomes de carbone qui peut contenir un groupe alkyle ayant de 1 à 6 atomes de carbone en tant que groupe substituant, un cycle aromatique ayant de 5 à 7 atomes de carbone qui peut contenir un groupe alkyle ayant de 1 à 6 atomes de carbone en tant que groupe substituant, ou un groupe combiné de ceux-ci ; R⁴ représente un atome d'hydrogène ou groupe méthyle ; PB représente le polybutadiène produit par le procédé selon l'une quelconque des revendications 1 à 3 ; et n représente 1 ou 2).
